# EUROPÄISCHE PATENTSCHRIFT

(11) **EP 1 483 613 B1**
(45) Veröffentlichungstag und Bekanntmachung des Hinweises auf die Patenterteilung: **12.10.2011**
(21) Anmeldenummer: 02722006.0
(22) Anmeldetag: 08.03.2002
(51) Int. Cl.: G02B 6/42

(54) **AUFNAHME- UND KOPPELTEIL FÜR EIN OPTO-ELEKTRONISCHES SENDE- ELEMENT**
RECEIVING AND COUPLING PART FOR AN OPTO-ELECTRONIC TRANSMITTING ELEMENT
PARTIE DE RECEPTION ET DE COUPLAGE POUR UN ELEMENT EMETTEUR OPTOELECTRONIQUE

(43) Veröffentlichungstag der Anmeldung: 08.12.2004
(73) Patentinhaber: Avago Technologies Fiber IP (Singapore) Pte. Ltd., Singapore 768923 (SG)
(72) Erfinder: SCHUNK, Nikolaus, 93142 Maxhütte-Haidhof (DE); WITTL, Josef, 92331 Parsberg (DE)
(74) Vertreter: Dilg, Andreas
(86) Internationale Anmeldenummer: PCT/DE2002/000903
(87) Internationale Veröffentlichungsnummer: WO 2003/077002

(56) Entgegenhaltungen:
- EP-A2- 0 053 483
- WO-A1-98/06141
- DE-A- 19 909 242
- GB-A- 1 304 428
- US-A- 4 076 376
- US-A- 5 815 623
- US-A- 6 040 523
- GE Plastics; 1 October 2001 (2001-10-01), GE PLASTICS: "Valox Profil",

## Beschreibung

Bezeichnung der Erfindung: Aufnahme- und Koppelteil für ein opto-elektronisches Sende- und/oder Empfangselement.

Die Erfindung betrifft ein Aufnahme- und Koppelteil für ein opto-elektronisches Sende- und/oder Empfangselement. Das Aufnahme- und Koppelteil mit einem entsprechenden Sende-und/oder Empfangselement ist bevorzugt Teil eines kostengünstigen opto-elektronischen Moduls, dass mit einer POP (plastic optical fibre)-Lichtleitfaser gekoppelt wird.

Aus der DE 199 09 242 A1 ist ein opto-elektronisches Modul bekannt, bei dem ein Träger mit einem opto-elektronischen Wandler in einem Modulgehäuse positioniert ist. Der Träger ist mit einem lichtdurchlässigen, formbaren Material umgeben, dass die optischen und auch die elektrischen Bauteile vor Umwelteinflüssen schützt. Aufgrund eines relativ großen Gießvolumens wird bei der Aushärtung eine relativ lange Prozesszeit benötigt. Nachteilig ist auch, dass es in Folge unterechiedlicher Ausdehnungskoeffizienten von Träger, Bauteilen und Vergussmasse zu einer nur eingeschränkten Stabilität bezüglich Temperaturschwankungen kommt und Spannungen auftreten. Die auftretenden Spannungen sind um so größer, je größer das Gehäuse und die eingebauten Teile sind.

Bei dem bekannten Gehäuse ergibt sich zwischen der Gießöffnung des Gehäuses und der optischen Achse eines Ankoppelbereichs zur Aufnahme einer Lichtleitfaser ein Winkel von 90°. Dies kann bei der Ausbildung von Linsen im Formkörper zu Problemen insofern führen, als sich bei einer nichtvollständigen Füllung der Linsenform eine Luftblase bildet, die die Effektivität der Linse stark reduziert.

Die GB 1304428 A beschreibt eine fiberoptische Vorrichtung mir einer Empfangs-LED-Diode, die auf einem runden Aufnahmekopf angeordnet ist. Ferner ist ein kreisförmiges Außengehäuse vorgesehen, das mit einem optisch durchlässigen Versiegelungsmaterial gefüllt ist.

Die US 4076376 beschreibt ein optisches Übertragungssystem mit einem mit einer Bohrung versehenem Verbinder, in dem ein Detektor angeordnet ist.

Die US5815623 beschreibt eine opto-elektronische Anordnung mit einem optoelektronischem Element in einem Aufnahme und Koppelteil von zylindrischem Querschnitt, wobei das Element mit einer Vergussmasse umgeben ist und in einem Ende des Hohlzylinders angeordnet ist; das andere Ende des Hohlzylinders dient der Aufnahme einer Lichtleitfaser. Der Hohlzylinder ist aus einem elektrisch leitenden Kunststoffmaterial und mit der Masseleitung des Elementträgers verbunden.

Die US6040523 und die US1304428 zeigen ähnliche Kopplungsanordnungen; allerdings ist hier das Element nicht auf einem Träger sondern auf einem sogenannten Leadframe angebracht.

Der vorliegenden Erfindung liegt die Aufgabe zugrunde, ein Aufnahme- und Koppelteil für ein Sendeelement zur Verfügung zu stellen, das die Anordnung des Sende- und/oder Empfangselementes in einer transparenten Vergussmasse und die Ankopplung einer Lichtleitfaser in einfacher Weise ermöglicht und dabei ein hohes Maß an Stabilität gegenüber Temperaturschwankungen bereitstellt. Gleichzeitig soll die Ausbildung von Luftblasen an einer in die Vergussmasse integrierten Linse möglichst vermieden werden.

Diese Aufgabe wird erfindungsgemäß durch ein Aufnahme- und Koppelteil mit den Merkmalen des Anspruchs 1 gelöst. Bevorzugt und vorteilhafte Ausgestaltungen der Erfindung sind in den Unteransprüchen angegeben.

Danach zeichnet sich die erfindungsgemäße Aufnahme- und Koppeleinheit dadurch aus, dass das Aufnahme- und Koppelteil eine zylindrische Aussparung aufweist, deren eines Ende das Sende- und/oder Empfangselement enthält und deren anderes Ende der Aufnahme und Ankopplung einer Lichtleitfaser dient. Das Aufnahme- und Koppelteil ist somit im wesentlichen ein Zylinder, an dessen einem Ende der Formkörper ausgebildet wird. Es liegt einen einfache symmetrische und kostengünstige Struktur für das Aufnahme- und Koppelteil vor.

Dabei kann eine Befüllung des Aufnahme- und Koppelteils mit dem Vergussmaterial in Richtung der optischen Achse der zylindrischen Aussparung bzw. in Richtung der Zylinderachse erfolgen. Das andere Ende des Zylinders wird mit einem Stempel mit negativer Linsenform unten verschlossen. In dieser bildet sich die positive Linsenform durch Abformung ab. Aufgrund der Ausbildung des Vergusskörpers unmittelbar in der zylindrischen Aussparung, an die eine anzukoppelnde Lichtleitfaser angekoppelt wird, kann das Vergussmaterial so klein wie möglich gehalten werden, wodurch auch Spannungen durch unterschiedliche Ausdehnungskoefizienten reduziert sind. Zusätzlich wir die Aushärtezeit entsprechend verkürzt. Da die Gießrichtung mit der optischen Achse zusammenfällt, und nicht wie im Stand der Technik unter einem Winkel von 90° zur optischen Achse erfolgt, ist die Linse beim befüllvorgang stets vollständig mit Vergussmaterial gefüllt, so dass nicht die Gefahr besteht, dass Luftblasen im Linsenbereich verbleiben.

Die Wandung des Aufnahme- und Koppelteils besteht bevorzugt aus einem leitenden Kunststoffmaterial und/oder ist mit einer leitenden elektrischen schicht unmantelt. Hierdurch wird die elektromagnetische Abstrahlung im optischen sendeelement absorbiert und kann die elektromagnetische Strahlung den offen Teil (d. h. den Ankoppelbereich), des Aufnahme- und Koppelteils nur stark gedämpft verlassen. Die zylindrische Aussparung wirkt dabei quasi als ein Hohlleiter, der weit oberhalb der cut-off Wellenlänge betrieben wird.

Bei dem Träger handelt es sich um einen Leadframe. Es ist dabei vorgesehen, dass das Aufnahme- und Koppelteil über den Leadframe mit Masseleitungen-verbunden wird, die derart in das Aufnahme- und Koppelteil eingefügt werden, dass die Justage eines optischen Sende- und Empfangselemtes in allen drei Dimensionen zur optischen Achse und zu den Außenabmaßen des Aufnahme und Koppelteil erfolgen kann. Es sind also bevorzugt Ausformungen vorgesehen, die in einem einfachen Fügeschritt die optischen Elemente und die optische Achse im Bezug zu dem Außendurchmesser des Aufnahme-und Koppelteils setzen. Die Positionierung des optischen Elementes auf dem Leadframe erfolgt dabei mit einer hohen Ablagegenauigkeit im Bezug auf die optische Achse.

Bevorzugt stimmt der Innendurchmesser der zylindrischen Aussparung mit dem Außendurchmesser einer anzukoppelnden Lichtleitfaser überein. Durch Einstecken der Lichtleitfaser, bei der es sich insbesondere um eine Plastikfaser, eine HPCS/HCS-Faser oder eine Multimodeglasfaser mit 50 µm Kerndurchmesser handelt, in das Aufnahme- und Koppelteil, wird die Lichtleitfaser auf der optischen Achse sicher gehalten.

Zur Positionierung des Leadframes sind passive Justagestrukturen am Aufnahme- und Koppelteil und am Leadframe vorgesehen, die ineinandergreifen.

Im Bereich der Faserführung ist das Aufnahme- und Koppelteil zylinderförmig ausgebildet, so dass im Innenzylinder die optische Faser geführt wird. Durch den Außenzylinder kann das Aufnahme- und Koppelteil in einem Steckergehäuse fixiert werden. Zur Montage des Aufnahme- und Koppelteils an einem Steckergehäuse und/oder an einer Schaltungsplatine weist das Aufnahme- und Koppelteil passive Justagemarken auf.

Weiter kann vorgesehen sein, dass an den Außenzylinder, d. h. die Außenseite der Wandung der zylindrischen Aussparung, Stege zur mechanischen Arretierung aufgebracht sind. Bei einer Montage des Aufnahme- und Koppelteils an einem Steckergehäuse kann das Aufnahme- und Koppelteil auf diese Weise gegen ein Herausschieben gesichert werden. Solchen beispielsweise U-förmig angebrachten Sicherungen können für ein Aufnahme- und Koppelteil mit Sendeelement oder mit Empfangselement unterschiedlich ausgeführt sein. Eine Arretierung könnte auch durch eine kleine keilförmige Erhöhung ringförmig auf der Außenwand bereitgestellt werden.

Zur Ausführung der Sende- bzw. Empfängerkomponente eines Transceivers müssen nicht immer zwei getrennte Aufnahme- und Koppelteile eingesetzt werden. Ebenfalls kann vorgesehen sein, dass das Aufnahme- und Koppelteil als Doppelkammer ausgebildet ist, die in parallelen, getrennten Bereichen das Sende- und das Empfangselement aufweist. Der Abstand der beiden Zylinderachsen entspricht dabei dem Abstand der beiden Achsen der Lichtwellenleiter eines mechanischen Stecksystems. Eine Arretierung mit uhrförmiger Drehung ist dann nicht mehr möglich. Eine Arretierung erfolgt beispielsweise durch eine keilförmige Ringstruktur auf den beiden Außenzylindern.

Eine passive Justage ist bei diesem Ausführungsbeispiel durch die Abmaße der beiden Außenzylinder gegeben, die formschlüssig in die entsprechenden Aussparungen an einem zugehörigen Steckergehäuse passen. Um ein elektrisches Übersprechen von dem Sendewandler auf den Empfangswandler zu unterdrücken, ist die Verbindungswand zwischen den beiden Kammern elektrisch leitend ausgestaltet. Dies kann beispielsweise durch eine elektrisch leitende Vergussmasse geschehen.

Eine andere Ausführungsform sieht zur Vermeidung eines elektrischen Übersprechens Öffnungen in der Verbindungswand vor. Diese sind dabei derart ausgeführt, dass sie mit einer elektrisch leitenden Schicht überzogen bzw. gefüllt sind und eine metallisch leitende Wand für die elektro-magnetische Abstrahlung darstellen.

Die Erfindung wird nachfolgend unter Bezugnahme auf die Figuren der Zeichnungen anhand mehrerer Ausführungsbeispiele näher erläutert. Es zeigen:
Figur 1 den grundlegenden Aufbau eines Aufnahme- und Koppelteils;
Figur 2 ein Aufnahme- und Koppelteil gemäß Figur 1 mit daran angeordneten Masse-Pins in geschnittener Seitenansicht und in Draufsicht;
Figur 3 ein weiteres Ausführungsbeispiel eines Aufnahme-und Koppelteils zusammen mit einem Steckergehäuse, das auf das Aufnahme- und Koppelteil aufsetzbar ist;
Figur 4 einen Schnitt durch ein Aufnahme- und Koppelteil bei der Anordnung eines Fotodetektors;
Figur 5 einen Schnitt durch ein Aufnahme- und Koppelteil bei der Anordnung eines Sendeelementes und nach Abtrennen des Leadframes;
Figur 6 das fertigmontierte Aufnahme- und Koppelteil in der Empfängerausführung in der Vorderansicht und in Schnittansicht;
Figur 7 das montierte Aufnahme- und Koppelteil in der Sendeausführung in der Vorderansicht und als Schnittansicht;
Figur 8 die Ankopplung eines Aufnahme- und Koppelteils in einem Steckergehäuse;

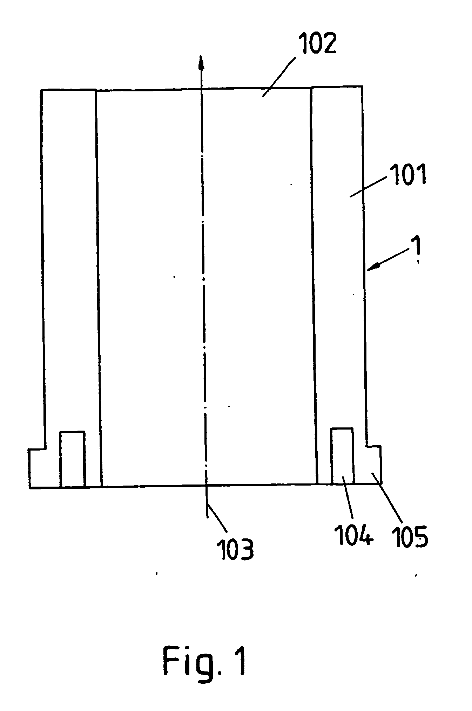

Figur 1 zeigt die Grundkomponente eines Aufnahme- und Koppelteils. Diese besteht aus einem Zylinder 1, der eine Zylinderwandlung 101 aufweist, die eine zylindrische Aussparung 102 definiert und umgibt. Der Zylinder 1 ist symmetrisch ausgebildet und weist eine optische Achse 103 auf. Die Achse 103 bildet die optische Achse eines Sende- bzw. Empfangselementes, das in dem Aufnahme- und Koppelteil in einem Vergussmaterial angeordnet wird. Der Zylinder 1 besteht aus einem leitenden Spritzgussmaterial oder ist mit einer elektrisch leitenden Ummantelung umgeben.

Zur Aufnahme eines einen Träger bildenden Leadframes mit dem jeweiligen optischen Wandlerelement (beispielsweise RCLED) ist das Aufnahme- und Koppelteil mit Aufnahmebuchsen 104 versehen und Zylinderwand in diesem Bereich 105 verstärkt. In die Aufnahmebuchsen 104 werden Masse-Pins des Leadframes eingeführt, die die Masseverbindung vom Aufnahme- und Koppelteil zur Masseschirmung mit der Leiterplatte sicherstellen.

Das Aufnahme- und Koppelteil 1 stellt ein auch als CAI-(Cavity-AS-Interface) Gehäuse bezeichnetes Teil dar, das zum einen der Aufnahme eines Sende- elementes, angeordnet auf einem Träger in einem Vergussmaterial, und zum anderen der Ankopplung einer Lichtleitfaser dient. Es wird im folgenden auch als CAI-Gehäuse 1 bezeichnet.

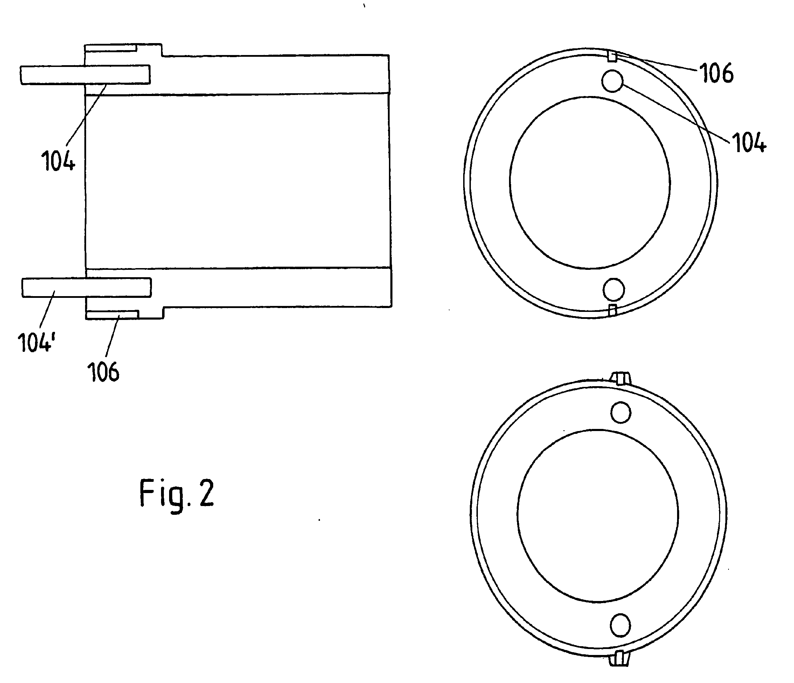

In der Figur 2 sind leicht alternative Ausführungsvarianten dargestellt, bei der Masse-Pins 104' bei der Herstellung des CAI-Gehäuses direkt mit eingespritzt werden. Die Justage eines Leadframes erfolgt dann über Führungsnuten 106 am Randbereich des Zylinders 1.

Mittels des CAI-Gehäuses sind alle geometrischen Abmaße in Bezug auf die optische Ankopplung einer Lichtleitfaser vorgegeben. Somit stellen die Abmaße Außendurchmesser, Innendurchmesser und die freie Weglänge bis zum Gießkörper im CAI-Gehäuse ein standardisiertes mechanisches Interface zu einem anzukoppelnden Stecker dar. Die Abmaße eines Steckergehäuses müssen den Abmaßen des CAI-Gehäuses angepasst sein, damit das CAI-Gehäuse passgenau in ein Steckergehäuse eingebaut werden kann.

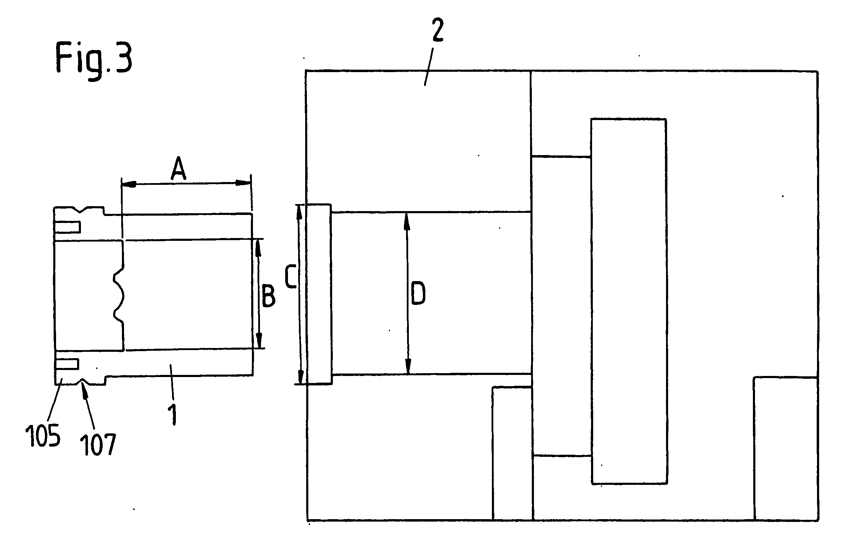

In der Figur 3 sind die wesentlichen Abmaße A, B, C, D dargestellt, die vom CAI-Gehäuse in ein Steckergehäuse 2 übertragen werden müssen.

Bei dem Ausführungsbeispiel der Figur 3 weist der Zylinder 1 ebenfalls einen verstärkten Randbereich 105 auf; dieser ist mit einem Formschlussbereich, beispielsweise einem umlaufenden Graben 107 versehen, der es erlaubt, das CAI-Gehäuse auch in der Wand des Steckergehäuses 2 zu arretieren. Eine vollständige Umhüllung des CAI-Gehäuses durch das Steckergehäuse ist damit nicht erforderlich. Vielmehr kann ersteres auch freibleibend als Rüssel in das Steckergehäuse 2 hineinragen.

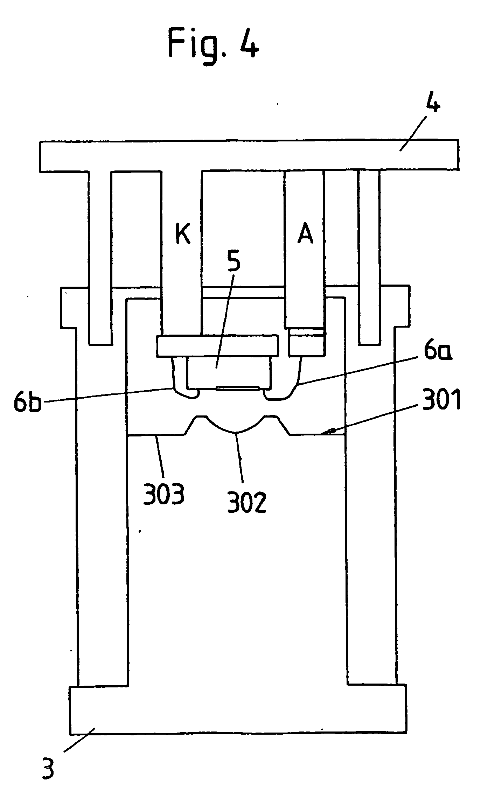

Figur 4 zeigt einen Schnitt durch den Aufbau zur Herstellung eines exemplarischen Fotodetektors. Das CAI-Gehäuse mit dem Zylinder 1 ist unten durch einen Stempel 3 verschlossen. Auf der Stempeloberfläche 301 ist eine Ankoppellinse 302 in negativer Form und mit Faseranschlagssicherung ausgeführt. Die Faseranschlagssicherung bzw. ein Faseranschlagsring ist im Außenbereich ausgebildet und weist einen etwa 50 µm langen Vorsprung 303 in Bezug auf den Linsenscheitel auf. Ein Leadframe 4 mit einer Fotodiode 5 ist in den Gießkörper eingetaucht und wird ausgehärtet. Ein Befüllen des Zylinderinneren mit einer Vergussmasse erfolgt dabei in Richtung der optischen Achse, also von oben.

Der Leadframe bildet einen Katodenkontakt K und einen Anodenkontakt A aus, die sich in Richtung der optischen Achse erstrecken. Über einen Bonddraht 6a, 6b erfolgt jeweils eine Kontaktierung der Fotodiode 5.

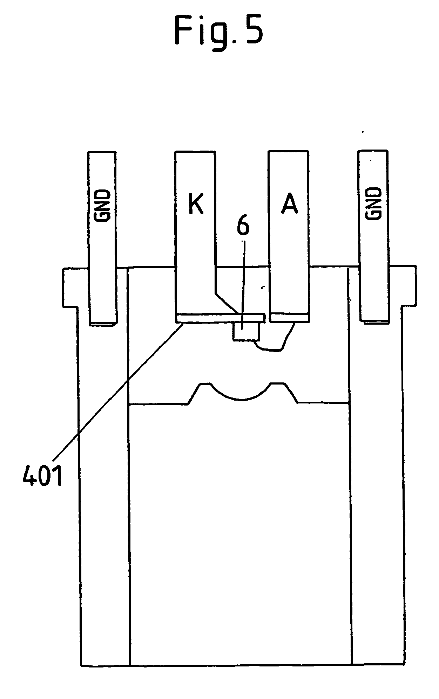

Die Figur 5 zeigt eine Anordnung entsprechend der Anordnung der Figur 4 mit einem Sendeelement 6. Es wird darauf hingewiesen, dass der Leadframe mit den Kontaktelementen K, A einen um 90° abgewinkelten Bereich 401 ausbildet, auf dem das Sendeelement 6 bzw. bei der Figur 4 das Empfangselement 5 montiert wird.

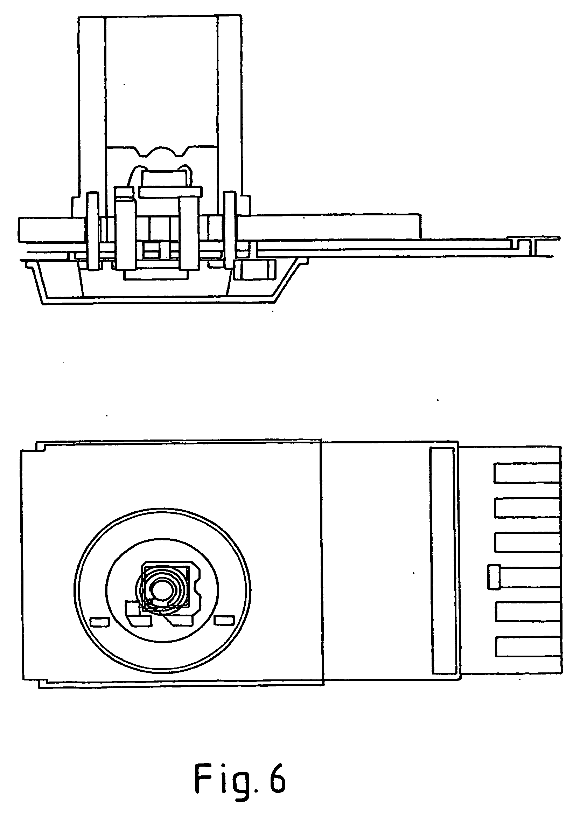

Figur 6 zeigt das montierte CAI-Gehäuse mit eine Allaminierten Flexfolienschaltungsträger in der exemplarischen Empfängerausführung in der Vorderansicht und als Schnittansicht. Die "Optik" ist auf den Bereich des transparenten Gießkörpers beschränkt. Die elektrische Beschaltung ist im Stand der Technik realisiert. Die Al-Folie dient zum einen der Abschirmung gegen elektro-magnetische Strahlen und zum anderen der Wärmeabfuhr.

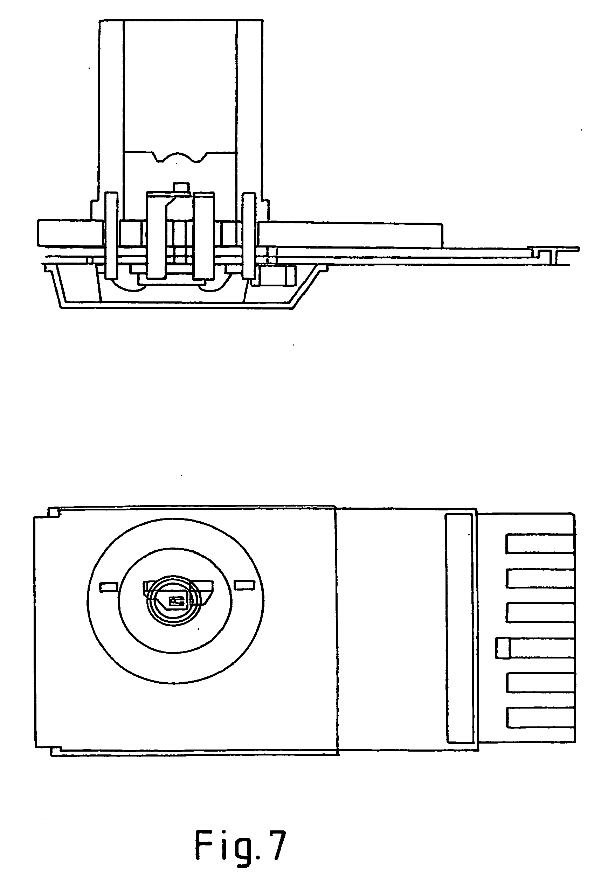

Die Figur 7 zeigt das montierte CAI-Gehäuse auf einem Allaminierten Flexfolienschaltungsträger in der Sendeausführung.

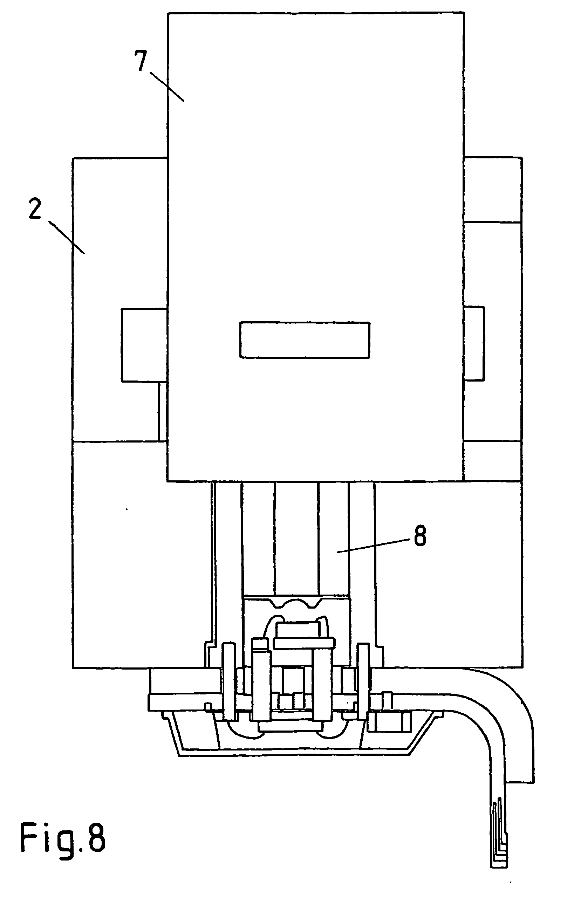

In Figur 8 ist die Ankopplung des CAI-Gehäuses in der exemplarischen Empfängerausführung beispielhaft an einem SMI (Small Multimedia Interface-Steckergehäuse) 2 dargestellt. Ein aufgesteckter POF-Stecker 7 mit einer Lichtleitfaser 8 ist in das CAI-Gehäuse eingesteckt und wird ausschließlich durch die Abmaße des CAI-Gehäuses fixiert. Es liegt ein mechanisches Interface vor. Unter Einhaltung der standardisierten mechanischen Abmaße des CAI-Gehäuse kann mit diesem Konzept jedes Steckerbild mit einem optischen Transceiver, bestehend aus Sende- und Empfängerbaustein, versehen werden.

## Patentansprüche

1. Opto-elektronische Anordnung zur Ankopplung einer Lichtleitfaser mit
- einem optoelektronischen Sendeelement (6)
- einem Träger (4), auf dem das Sendeelement (6) angeordnet ist,
- einem Vergussmaterial, dass das Sendeelement (6) umgibt, und
- einem Aufnahme- und Koppelteil (1) mit einer Längsachse (103), das aufweist:
- eine Öffnung geeignet zum Einführen des Trägers (4), und
- eine zylindrische Aussparung (102), die als Durchgangsbohrung mit zylindrischem Querschnitt oder als zylindrische Sackbohrung ausgebildet ist, sich entlang der Längsachse (103) des Aufnahme- und Koppelteils (1) erstreckt und über ihre gesamte Länge einen konstanten Durchmesser aufweist, wobei
- das eine Endteil der Aussparung das Sendeelement (6) und das diesen umgebende Vergussmaterial enthält,
- das andere offene Endteil der Aussparung der Aufnahme und Ankopplung einer Lichtleitfaser dient,
- das Aufnahme- und Koppelteil (1) aus einem elektrisch leitenden Kunststoffmaterial besteht und/oder mit einer elektrisch leitenden Schicht ummantelt ist und dabei
- die zylindrische Aussparung (102) einen Hohlleiter darstellt, der weit oberhalb der cut-off Wellenlänge betrieben wird, **dadurch charakterisiert, dass**
der Träger (4) als Leadframe ausgebildet ist, über den eine elektrische Kontaktierung des Sendeelementes (6) erfolgt, und
wobei das Aufnahme- und Koppelteil (1) ausschließlich mit Masse-Pins des Leadframes (4) elektrisch verbunden ist und das Aufnahme- und Koppelteil Aufnahmebuchsen (104) zur Aufnahme der Masse-Pins aufweist.

2. Opto-elektronische Anordnung nach Anspruch 1, **dadurch gekennzeichnet, dass** die zum Einführen des Trägers geeignete Öffnung durch ein offenes Ende der als Durchgangsbohrung ausgebildeten zylindrischen Aussparung (102) gebildet wird, wobei die zylindrische Aussparung zwei offene Endteile aufweist und das andere offene Endteil der Aufnahme und Ankopplung einer Lichtleitfaser dient.

3. Opto-elektronische Anordnung nach mindestens einem der vorangehenden Ansprüche, **dadurch gekennzeichnet, dass** der Innendurchmesser der zylindrischen Aussparung (102) mit dem Außendurchmesser einer anzukoppelnden Lichtleitfaser (8) übereinstimmt.

4. Opto-elektronische Anordnung nach Anspruch 1, **dadurch gekennzeichnet, dass** der Leadframe (4) sich in seiner Längsausdehnung parallel zur Achse (103) der zylindrischen Aussparung (102) erstreckt.

5. Opto-elektronische Anordnung nach mindestens einem der vorangehenden Ansprüche, **dadurch gekennzeichnet, dass** das Vergussmaterial eine integrierte Linse (302) ausbildet.

6. Opto-elektronische Anordnung nach Anspruch 5, **dadurch gekennzeichnet, dass** die integrierte Linse (302) von einem in dem Vergussmaterial ausgebildeten Faseranschlagring (303) umgeben ist, der einen Anschlag der Stirnfläche einer Lichtleitfaser an der Koppellinse verhindert.

7. Opto-elektronische Anordnung nach mindestens einem der vorangehenden Ansprüche, **dadurch gekennzeichnet, dass** auf dem Träger (4) ausschließlich ein Sendeelement sowie ggf. eine Monitordiode angeordnet sind, nicht jedoch elektrische Treiber-oder Empfangsschaltungen.

8. Opto-elektronische Anordnung nach mindestens einem der vorangehenden Ansprüche, **dadurch gekennzeichnet, dass** an der Außenwand des Aufnahme-und Koppelteiles (1) Strukturen angeordnet sind zur Fixierung des Aufnahme-und Koppelteiles (1) an einem Steckergehäuse.

## Claims

1. An optoelectronic arrangement for coupling an optical fibre waveguide with
an optoelectronic transmitting element (6),
a carrier (4), on which the transmitting element (6) is arranged,
a casting material enclosing the transmitting element (6), and
a housing and coupling part (1) having a longitudinal axis (103), which comprises:
an opening capable for inserting the carrier (4), and
a cylindrical recess (102) formed as a through bore-hole having a cylindrical cross section or as a cylindrical blind hole, extending along the longitudinal axis (103) of the housing and coupling part (1), and having a constant diameter along its entire length, wherein
the one end part of the recess contains the transmitting element (6) and the casting material enclosing the same,
the other open end part of the recess serves for housing and coupling of an optical fibre waveguide,
the housing and coupling part (1) consists of an electrically conducting plastic material and/or is coated with an electrically conducting layer, and wherein
the cylindrical recess (102) constitutes a hollow conductor which is operated above the cut-off wavelength,
**characterized in that**
the carrier (4) is formed as a lead frame by which an electric contacting of the transmitting element (6) takes place, and
wherein the housing and coupling part (1) is electrically connected exclusively with ground pins of the lead frame (4) and the housing and coupling part comprises cups for housing of the ground pins.

2. The optoelectronic arrangement according to claim 1, **characterized in that** the opening capable for inserting the carrier (4) is formed by an open end of the cylindrical recess (102) which is formed as a through bore-hole, wherein the cylindrical recess comprises two open end parts and the other open end part serves for housing and coupling of an optical fibre waveguide.

3. The optoelectronic arrangement according to at least one of the preceding claims, **characterized in that** the inner diameter of the cylindrical recess (102) matches the outer diameter of an optical fibre waveguide to be coupled.

4. The optoelectronic arrangement according to claim 1, **characterized in that** the lead frame (4) extends, along its longitudinal extension, parallel to the axis (103) of the cylindrical recess (102).

5. The optoelectronic arrangement according to at least one of the preceding claims, **characterized in that** the casting material forms an integrated lens (302).

6. The optoelectronic arrangement according to claim 5, **characterized in that** the integrated lens (302) is surrounded by a fibre stop ring (303) formed in the casting material, which inhibits an abutting of the front face of an optical fibre waveguide on the coupling lens.

7. The optoelectronic arrangement according to at least one of the preceding claims, **characterized in that** only a transmission element as well as, if required, a monitor diode is arranged on the carrier (4), but no electrical driver or receiving circuits.

8. The optoelectronic arrangement according to at least one of the preceding claims, **characterized in that** structures are arranged on the outer wall of the housing and coupling part (1) for fixing the housing and coupling part at a connector casing.

## Revendications

1. Système optoélectronique pour le couplage d'une fibre optique avec :
- un élément d'émission optoélectronique (6),
- un support (4) sur lequel est disposé ledit élément d'émission (6),
- un matériau de scellement qui entoure l'élément d'émission (6), et
- une partie de réception et de couplage (1) avec un axe longitudinal (103)
qui comprend
- une ouverture adaptée à l'introduction du support (4), et
- un évidemment cylindrique (102) formé par un alésage traversant avec une section transversale cylindrique ou par un alésage borgne, ledit évidemment s'étendant le long de l'axe longitudinal (103) de la partie de réception et de couplage (1) et présentant sur toute sa longueur un diamètre constant,
- une partie d'extrémité de l'évidemment comprenant l'élément d'émission (6) et le matériau de scellement de celui-ci,
- l'autre partie d'extrémité ouverte de l'évidemment, ladite autre partie permettant la réception et le couplage d'une fibre optique,
- la partie de réception et de couplage (1) étant composée d'une matière plastique électro conductrice et/ou étant enrobée d'une couche électro conductrice et,
- l'évidemment cylindrique (102) représentant ainsi un guide d'ondes actionné largement au-dessus de la longueur d'onde de coupure, **caractérisé en ce que**,
- le support (4) est un support de connexion sur lequel est réalisé un contact électrique de l'élément (6) d'émission et,
- la partie de réception et de couplage (1) est reliée électriquement uniquement à des broches de masse (GND) du support de connexion (4) et comprend des douilles de réception et de couplage (104) adaptées à la réception et au couplage desdites broches de masse.

2. Système optoélectronique selon la revendication 1, **caractérisé en ce que** - l'ouverture adaptée à l'introduction du support est conçue à travers une extrémité ouverte de l'évidemment cylindrique (102) formé par un alésage traversant, ledit évidemment cylindrique comprenant deux extrémités ouvertes, et
- l'autre extrémité ouverte permet la réception et le couplage d'une fibre optique.

3. Système optoélectronique selon au moins l'une des revendications précédentes, **caractérisé en ce que** le diamètre intérieur de l'évidemment cylindrique (102) coïncidé avec le diamètre extérieur d'une fibre optique (8) à coupler.

4. Système optoélectronique selon la revendication 1, **caractérisé en ce que** le support de connexion (4) s'étend, dans son extension longitudinale, parallèlement à l'axe (103) de l'évidemment cylindrique (102).

5. Système optoélectronique selon au moins l'une des revendications précédentes, **caractérisé en ce que** le matériau de scellement forme une lentille intégrée (302).

6. Système optoélectronique selon la revendication 5, **caractérisé en ce que** la lentille intégrée (302) est entourée d'une bague (303) de butée pour fibre formée dans le matériau de scellement, ladite bague empêchant une butée de la surface frontale d'une fibre optique sur la lentille de couplage.

7. Système optoélectronique selon au moins l'une des revendications précédentes, **caractérisé en ce que**
- uniquement un élément d'émission ainsi qu'éventuellement une diode de contrôle sont disposées sur le support (4), mais
- aucun circuit de commande ou de réception électrique ne l'est.

8. Système optoélectronique selon au moins l'une des revendications précédentes, **caractérisé en ce que** des structures pour la fixation de la partie de réception et de couplage (1) à un boîtier de connexion sont disposées sur une paroi extérieure de ladite partie de réception et de couplage (1).
